Europäisches Patentamt

European Patent Office

Office européen des brevets

(11) Publication number: 0 069 191
A1

(12) **EUROPEAN PATENT APPLICATION**

(21) Application number: 82101439.6

(22) Date of filing: 25.02.82

(51) Int. Cl.³: H 01 L 21/76
H 01 L 27/08

(30) Priority: 25.06.81 US 277465

(43) Date of publication of application:
12.01.83 Bulletin 83/2

(84) Designated Contracting States:
DE FR GB

(71) Applicant: Rockwell International Corporation
2230 East Imperial Highway
El Segundo, California 90245(US)

(72) Inventor: Soclof, Sidney Isaac
6419 N. Lemon
San Gabriel California 91775(US)

(74) Representative: Wagner, Karl H.
P.O. Box 246 Gewürzmühlstrasse 5
D-8000 Munich 22(DE)

(54) Complementary NPN and PNP lateral transistors separated from substrate by intersecting slots filled with substrate oxide for minimal interference therefrom and method for producing same.

(57) The invention is a pair of complementary transistors or arrays thereof and method for producing same in sub-micron dimensions on a silicon substrate selectively doped P and N type by forming intersectings slots (4, 5) in spaced apart relation across the P substrate regions to define semi-arrays of V shaped intermediate regions which will become transistors. Silicon oxide fills these slots and separates the NPN transistor regions from the substrate. Orthogonal slots (8, 9) divide the semi-arrays into individual transistor active regions; N doping is then introduced into each active region via the orthogonal slots and driven in to form the emitter and collector regions on respective sides of original substrate which forms the base regions. The same construction obtains in the N substrate regions to form the arrays of PNP transistors. Metallization patterns complete electrical connections to the emitter, base and collector regions and silicon oxide substantially covers the periphery of each active region for total isolation.

FIG. 1

Croydon Printing Company Ltd.

### COMPLEMENTARY NPN AND PNP LATERAL TRANSISTORS SEPARATED FROM SUBSTRATE BY INTERSECTING SLOTS FILLED WITH SUBSTRATE OXIDE FOR MINIMAL INTERFERENCE THEREFROM AND METHOD FOR PRODUCING SAME

Filed of the Invention

This invention is a novel structure and method for forming sub-micron type lateral dielectrically isolated complementary transistors utilizing VLSI chip processing steps to compatibly fabricate hundreds of such devices, simultaneously on a common functional chip.

Background of the Invention

Techniques extracted from the prior art come from the field of sub-micron fabrication technology wherein the dimensional resolution is now comparable to or even smaller than the thicknesses of the thermally grown silicon oxide layers on silicon. Also, the dimensions are now comparable or even smaller than the base widths used for fused transistors, i.e., 0.4 to 1.0 micrometers. From these techniques, the novel structure and method for the complementary lateral transistors with greatly reduced parasitic capacitances and resistances are achieved.

Summary of the Invention

The invention comprises novel lateral complementary transistors formed on a selectively doped substrate by intersecting slots and orthogonal slots for respectively defining each active region undercut by selective intersecting slots and filled with substrate oxide to isolate the effective regions from the substrate. Prior to oxidation filling the orthogonal slots, selective doping is introduced by angle implantation from opposed orthogonal surfaces of each individual active region to complete the NPN formations or the complementary PNP formations.

The intersecting slots and the orthogonal slots of the complementary devices are respectively orthogonally related. Electrical connections are made in conventional fashion to become emitter, base and collector regions.

Brief Description of the Drawings

FIGURE 1 shows a portion of a chip including separate formations of NPN and PNP devices;

FIGURE 2 is a cross sectional view through the substrate showing the formation of intersecting slots;

FIGURE 3 shows a substrate oriented at an angle above the horizontal such that vertical milling may form the diagonally penetrating slots;

FIGURE 4 shows the substrate oppositely oriented to that of FIG. 3 such that vertical milling may again form the other portion of the intersecting slots;

FIGURE 5 is a view in top plan of the substrate showing the spaced apart intersecting slots with support regions between the ends thereof;

FIGURE 6 is a front view of the triangular semi-arrays of substrate formed by the intersecting slots and separated from the substrate proper;

FIGURE 7 shows the introduction of orthogonal slots relative to the pairs of intersecting slots;

FIGURE 8 shows the formation of the orthogonal slots via milling;

FIGURE 8A illustrates angled doping;

FIGURE 9 is a view of a single active transistor region following N+ doping via the orthogonal slots and prior to oxidation filling the same;

FIGURE 10 is a view of the structure of FIG. 9 with metallization contacts for the emitter, base and collector regions; and,

FIGURE 11 shows a PNP active region, per se.

Brief Description of a Preferred Embodiment of the Invention

In the devices produced in accordance with the present invention, the effects of the substrate are minimized relative to the operation of the devices. It should be realized that the isolated active region may be completely contained within a surface area of approximately $5d \times 3d = 15d^2$ wherein d is only 0.4 micrometers. Each active region is completely separated from the substrate by substrate oxidation and the parasitic capacitances and resistances are almost completely reduced to a minimum value attainable because the transistors are reduced to just their electronically active regions. In the conventional (vertical) transistor, the electrically active region is only a very small fraction of the total transistor area or volume. The dielectric isolation between transistors offered by the substrate oxidation has advantages with respect to high frequency performance, high voltage integrated circuits, radiation resistance, and circuit flexibility, i.e., the process provides NPN and PNP devices on the same integrated circuit chip.

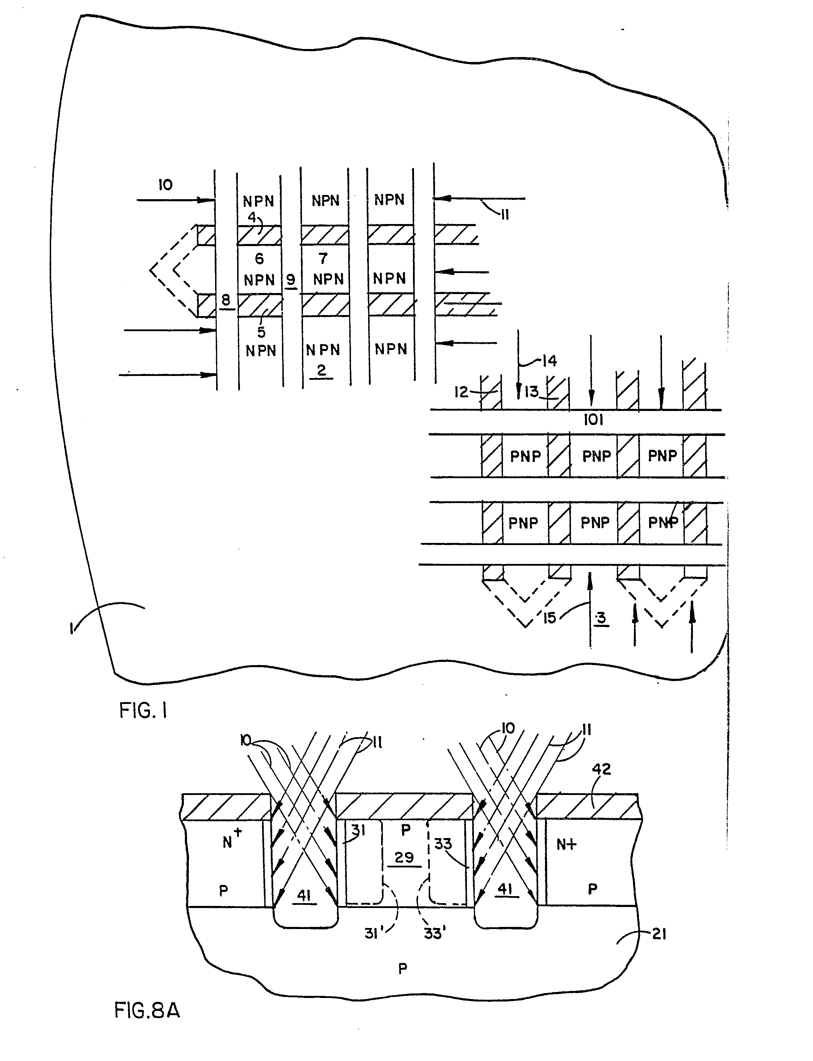

In Figure 1, the chip or die is partly shown at 1 carrying an NPN formation of transistors structures 2 and a separate PNP formation of transistor structures 3.

In formation 2, a pair of intersecting slots 4 and 5 form triangular shaped active regions 6 and 7 separated by orthogonal slots 8 and 9. The arrows 10 and 11 illustrate the angle doping paths (when tilted upwardly) for N or N+ doping of the underlying substrate. Subsequently, slots 8 and 9 are also filled with oxide and electrical connections are established to the electrode regions of the isolated active transistor regions.

In formation 3, the intersecting slots 12 and 13 of the P region are illustrated orthogonal to intersecting slots 4 and 5 of the N region 2, and the directions of angled doping, shown by arrows 14 and 15, is at right angles to arrows 10 and 11 of region 2. Since ion milling and ion doping are preferably employed, many regions, such as 2 and 3, may be selectively distributed across the chip 1, and accurately indexed by present day conventional techniques. This offers versatility of association of the complementary transistors. Use of the ullistrated orthogonal relationship of slots 8 and 9 to slots 101 and 102 serves to prevent contaminating of doping (i.e.) N type doping is only injected at right angles to P type doping.

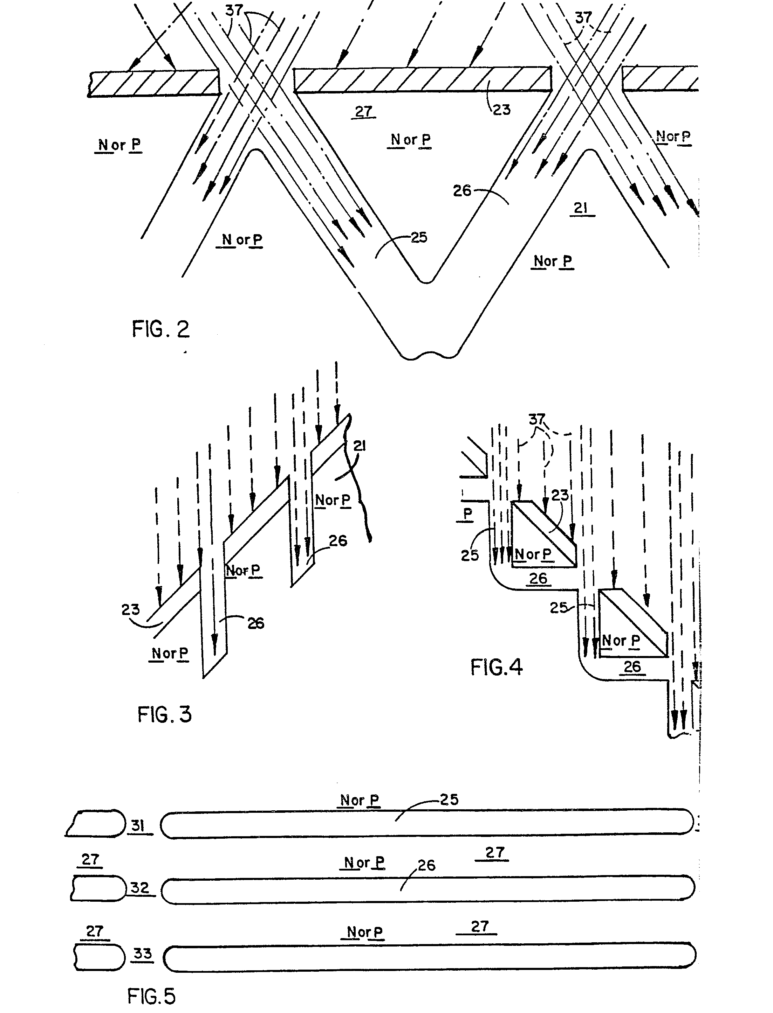

Referring now to Figure 2, substrate 21 is masked by photoresist 23 which is patterned to define the penetration regions for intersecting slots 25 and 26. Since substrate 21 is shown doped N or P type, the intermediate region 27 will eventually comprise a plurality of transistors of either the NPN or PNP type, having been carved from the substrate by the slots 25 and 26. To prevent intermediate region 27, better defined as a semi-array of transistor regions, from falling into substrate 21, it should be noted that the slots 25 and 26 are interrupted to leave shoulders at spaced apart intervals therealong, best seen at 31, 32 and 33 in Fig. 5.

Since the preferred way of forming slots 25 and 26 is by ion milling, shown by the flux lines 37 in Fig. 2, the masking layer 23 is a material with a low sputtering rate, such as one of the heavier metals.

Figures 3 and 4 illustrate the ease of forming intersecting slots, such as 25 and 26, simply by orienting the substrate at angles, e.g., 60° to the horizontal, such that the ion flux 37 may remain in its vertical pattern to form, first slots 26, and thereafter slots 25 simply by rotating the substrate 21 through 90°. The flux may be accurately directed to any region 2 or 3.

While the triangular array 27 is shown as being substantially equilateral, it need not be and the angles may be varied to configure the active regions as desired for specific purposes. It will also be noticed from Figs. 3 and 4 that slots 25 and 26 terminate where they intersect because extending them deeper into the substrate would serve no purpose.

From Fig. 5, it may be seen that the slots 25 and 26 may be intermittent such that supporting ribs or webs 31, 32 and 31', 32' serve to support each semi-array 27. These webs or supports may be at spaced apart locations along the slots 25 and 26 or merely comprise only supports at the edges of the chips because they serve but a temporary purpose as the slots will be filled with substrate oxide to provide the permanent support for each transistor region.

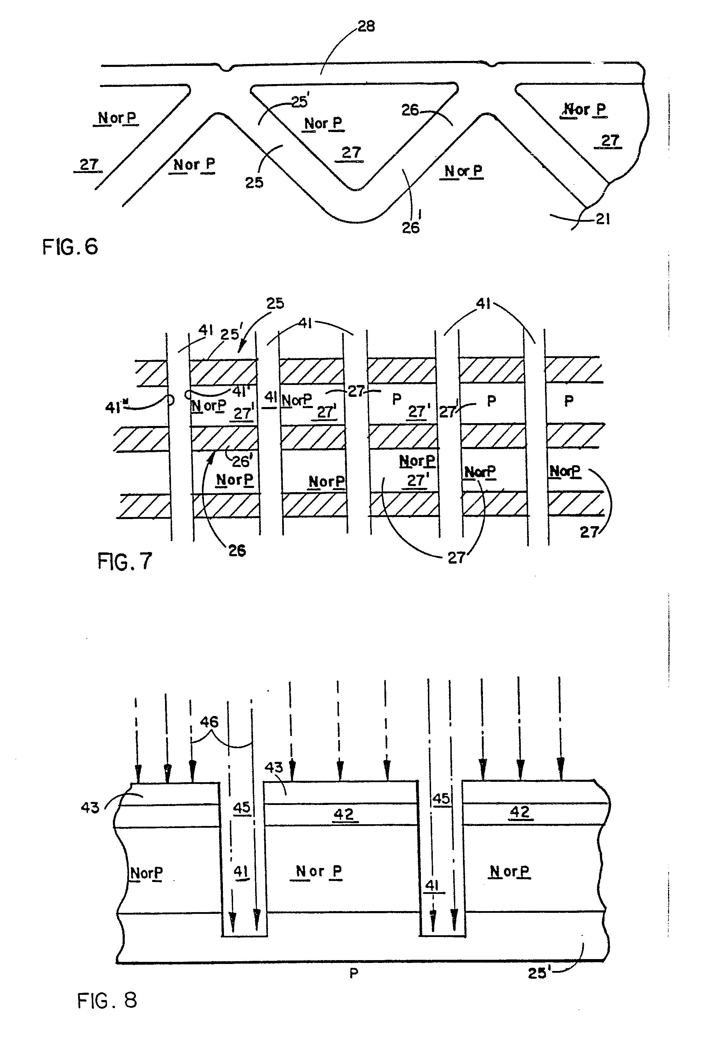

The first oxidation step is shown in Fig. 6 wherein silicon oxide 25' and 26' fills the respective slots 25 and 26. Also, an upper layer of silicon oxide 28 (Fig. 6) covers the upper surface and is continguous with the silicon oxide 25' and 26' such that semi-array 27 is totally isolated from the substrate 21 by the silicon oxide, and the periphery of the semi-arrays 27 are substantially covered by the oxide.

In Fig. 7, orthogonal slots 41 divide the semi-arrays 27 into the individual transistor regions 27' and provide ingress for the doping to follow. Thus, each orthogonal slots 41 includes sidewalls 41' through which individual transistor regions 27' will be doped. The other sidewalls 41" of slots 41 provide for doping adjacent transistor regions 27'. Slots 41 may be ion milled using the masking technique heretofore employed. Consequently, photoresist 43 (Fig. 8) of a heavier metal is patterned as shown in Fig. 8 to provide for ion milling slots 41 via the openings 45 in the heavy photoresist 43 and silicon oxide layer 42. The ion flux is illustrated by the lines 46.

In Fig. 8A, it may be seen that the N+ regions 31 and 33 are implanted by ion implanting at an angle as illustrated by the ion beams 32 and 34. It is important to note that the angle of the ion beams relative to the slot directions is such that the N+ implanting does not extend to the full depth of the slots 23 and 25. Actually the corners of the silicon oxide layer 42 form a shadowing effect and cooperate with the orientation of the beams 32 and 34 in fixing the N+ doped regions within the P active region 27. Phosphor or other donors may be employed in this step. Dotted lines 31' and 33' show that the doping has been driven in and the N+ regions 31 and 33 considerably enlarged. This may be accomplished through the application of heat over a controlled period of time and temperature.

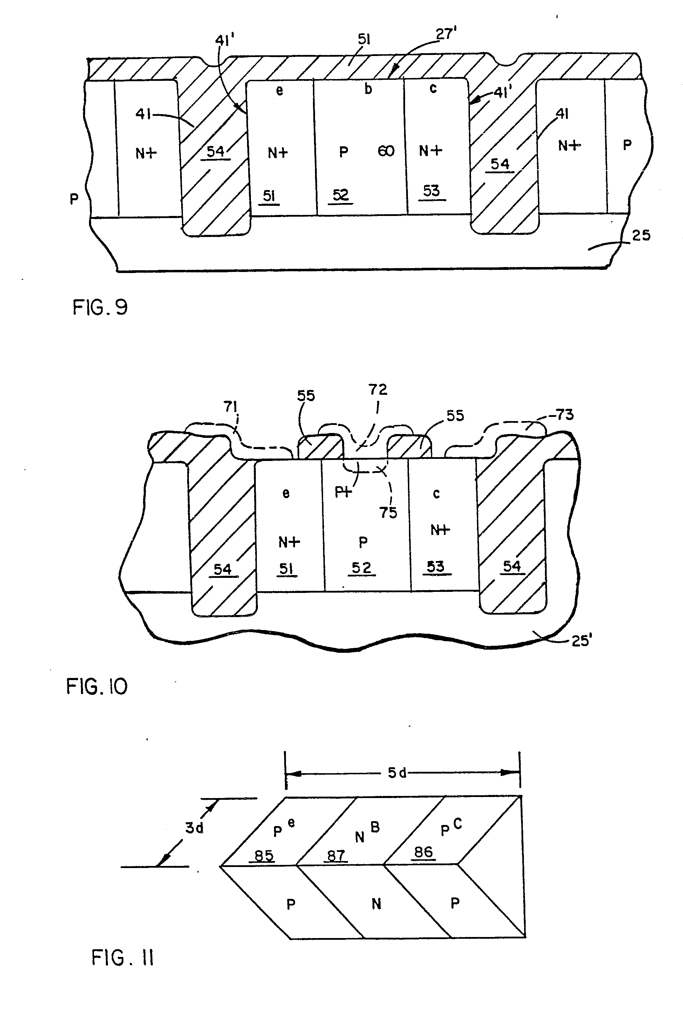

In Figure 9, an individual transistor region 27' is shown comprising N or N+ doped region 51, P or P+ doped region 52 and N or N+ doped region 53. The P region 52 is the base region and comprises a portion of the original substrate 21, e.g., doped P at formation 2 in Fig. 1.

However, both N+ regions 51 and 53 are provided by doping region 27' via the sidewalls 41' and 41" of orthogonal slots 41 (Fig. 7) with phosphorous deposition, diffusion or implantation plus drive-in to create the emitter region 51 and the collector region 53. Thereafter, the structure of Fig. 9 is oxidized to fill in slots 41 with silicon oxide 54 and provide covering layer 51.

The next step in the process is illustrated in Fig. 10 wherein the silicon oxide layer 51 has been patterned to leave oxide islands 55 and metallization applied to comprise the emitter electrode 71, base electrode 72 and collector electrode 73. However, prior to applying the metallization, a light boron deposit may be made in the base region 52 to provide the P+ base spanning region 75, if desired.

The purpose of the boron deposition 75 prior to the metallization is two fold, i.e., first to reduce the base region contact resistance and second to produce a potential barrier $\frac{P+}{P}$ that will deflect the electrons in transit across the base region 52 away from the base contact.

Finally, a PNP device can be built utilizing a P-type substrate in the manner of having built the NPN device starting from a P substrate as described in region 3 Fig. 1. This is shown in Fig. 11 wherein emitter region 85 is conventionally P doped, but by angled ion flux via the slots 101, 102 (Fig. 1) just as in the process for the NPN transistors. Collector region 86 is similarly formed, and base region 87 is part of the original N doped substrate 3 (Fig. 1).

Patterning of the silicon oxide on the top of this complementary device has been shown and it is only necessary to lay down the metallization pattern for electrical connection to the various transistor regions.

Interconnections of the complementary transistors may be established using conventional diffused lines, poly lines or metal patterning.

It should be mentioned that the N and P formations need not be at right angles but this arrangement insures that ion doping is carried out most efficiently and there are no components of doping intended for NPN transistors which dope the complementary PNP transistors. This orientation facilitates higher speed and more efficient processing.

The dielectrically isolated complementary transistors of this invention have no junction curvature and thus exhibit higher breakdown voltages. Also, they exhibit very low capacitances, i.e., $C_{cb}$, $C_{be}$, and $C_{cs}$. Similarly, bulk resistance is very low (i.e.) $r_{bb'}$, $r_{cc'}$ and $r_{ee'}$. Symmetrical transistors are readily available with very low $V_{CE}$ at $I_c = 0$. Also available is high $\beta$ at low current levels ($_L$ /MA), with no current crowding at the higher current levels. By the use of oversize geometry, close control over transistor parameters is possible with respect to the absolute values, and more importantly, the matching tolerances, partly due to the excellent control available with respect to base width since it is now a function of lateral geometry and not of the small differences of two diffusions as in conventional double diffused transistors.

WHAT IS CLAIMED IS:

1. An array of sub-micron dimensioned complementary NPN and PNP type lateral transistors formed on a silicon substrate doped P and N type, comprising in combination:

a plurality of first sidewalls of pairs of intersecting slots in spaced apart relation across the P regions of the substrate defining semi-arrays of V shaped intermediate regions which will become transistors;

silicon oxide filling said slots and covering the surface of the substrate through which they were made;

a plurality of second sidewalls of orthogonal slots relative to said pairs of slots dividing the semi-arrays of regions into individual transistor active regions;

selective doping introduced into said active regions via said second sidewalls and driven in to comprise emitter and collector regions on respective sides of original P and N substrate comprising the respective base regions;

metallization patterns in electrical connection with the respective emitter, base and collector regions; and,

silicon oxide at least substantially covering the periphery of each active region.

2. Transistor arrays in accordance with claim 1, wherein:

said intersecting slots for the NPN transistors are normal to said intersecting slots for the PNP transistors; and,

said orthogonal slots for the NPN transistors are normal to said orthogonal slots for the PNP transistors.

3. The transistor arrays in accordance with claims 1 and 2, wherein:

said selective doping comprises N doping for the P substrate regions and P doping for the N substrate regions.

4.  An array of sub-micron dimensioned PNP and NPN type lateral complementary transistors formed on a silicon substrate selectively doped N and P type in different substrate regions, comprising in combination:

a plurality of first sidewalls of pairs of intersecting slots in spaced apart relation across N doped regions of the substrate defining semi-arrays of V shaped intermediate regions which will become PNP transistors;

a second plurality of sidewalls orthogonal to said first sidewalls comprising further pairs of intersecting slots in spaced apart relation across P doped regions of the substrate defining semi-arrays of V shaped intermediate regions which will become NPN transistors;

silicon oxide filling said slots and covering the surface of the substrate through which they were made;

a plurality of second sidewalls of orthogonal slots relative to said pairs of slots dividing the semi-arrays of regions into individual transistor active regions;

N and P doping selectively introduced into selected ones of said active regions via said second sidewalls and driven in to comprise emitter and collector regions on respective sides of original N or P substrate comprising the base regions;

metallization patterns in electrical connection with the respective emitter, base and collector regions; and,

silicon oxide at least substantially covering the periphery of each active region.

5. A method for producing an array of sub-micron dimensioned PNP and NPN type lateral complementary transistors formed on a silicon substrate selectively doped N and P type, comprising the steps of:

    forming a plurality of first sidewalls of pairs of intersecting slots in spaced apart relation across N regions of the substrate defining semi-arrays of V shaped intermediate regions which will become transistors;

    forming a plurality of first sidewalls of pairs of intersecting slots in spaced apart relation across P regions of the substrate defining semi-arrays of V shaped intermediate regions which will become transistors;

    oxidizing the substrate and intermediate regions to fill said slots and cover the surface of the substrate through which they were made;

    forming a plurality of second sidewalls of orthogonal slots relative to said pairs of slots dividing the semi-arrays of regions into individual NPN and PNP transistor active regions;

    N or P doping selected ones of said active regions via said second sidewalls;

    driving in said doping to comprise emitter and collector regions on respective sides of original P and N substrate comprising the base regions; and,

    forming metallization patterns in electrical connection with at least the respective emitter, base and collector regions.

6. A method for producing an array of sub-micron dimensioned NPN and PNP type lateral complementary transistors formed on a silicon substrate doped selectively P and N-type, comprising the steps of:

forming a plurality of first sidewalls of pairs of intersecting slots in spaced apart relation across the N regions of the substrate defining semi-arrays of V shaped intermediate regions which will become PNP transistors;

forming a second plurality of first sidewalls of pairs of intersecting slots in spaced apart relation across the P regions of the substrate defining semi-arrays of V shaped intermediate regions which will become NPN transistors;

said second plurality of first sidewalls being normal to said first sidewalls of the first mentioned plurality but do not intersect them;

oxidizing the substrate and intermediate regions to fill said slots and cover the surface of the substrate through which they were made;

forming a plurality of second sidewalls of orthogonal slots relative to said first mentioned pairs of slots dividing the semi-arrays of regions into individual transistor active regions;

P doping each of said active regions via said second sidewalls;

forming a second plurality of second sidewalls of further orthogonal slots relative to said second plurality of first sidewalls of pairs of intersecting slots dividing the semi-arrays of regions into individual transistor active regions;

N doping each of said last mentioned active regions via said further orthogonal slots;

driving in said doping to comprise emitter and collector regions on respective sides of original N and P substrate comprising the base regions; and,

forming metallization patterns in electrical connection with at least the respective emitter, base and collector regions.

7.  A method for producing arrays of sub-micron dimensioned lateral complementary transistors formed on a silicon substrate selectively doped P and N type, comprising the steps of:

forming a plurality of first pairs of intersecting slots in spaced apart relation across the selective N portions of the substrate defining semi-arrays of V shaped intermediate regions which will become PNP transistors;

forming a plurality of second pairs of intersecting slots in spaced apart relation across the selective P portions of the substrate defining semi-arrays of V shaped intermediate regions which will become NPN transistors;

said second pairs being normal to said first pairs and out of contact therewith;

silicon oxide filling said slots and covering the surface of the substrate through which they were made;

forming a plurality of orthogonal slots relative to said first pairs of slots dividing the semi-arrays of N regions into individual PNP transistor active regions;

P doping each of said N active regions via said orthogonal slots;

forming a second plurality of orthogonal slots relative to said second pairs of slots dividing the semi-arrays of P regions into individual NPN transistor active regions;

N doping each of said P active regions via the second plurality of orthogonal slots;

driving in said doping to comprise emitter and collector regions on respective sides of original substrate comprising the base regions; and,

forming conductor patterns in electrical connection with the respective emitter, base and collector regions.

8. A pair of NPN PNP complementary transistors formed on a common substrate, comprising in combination:

an N doped portion of said substrate;

a pair of intersecting slots in said portion filled with substrate oxide defining the length of the PNP transistor;

an orthogonal pair of slots in said N portion relative to said intersecting slots through which P doping is driven into the ends of said PNP transistor to comprise the collector and emitter respectively, said base being comprised of N doped substrate;

said orthogonal slots filled with substrate oxide;

a P doped portion of said substrate;

a second pair of intersecting slots in said P portion filled with substrate oxide defining the length of the NPN transistor;

a second pair of orthogonal slots in said P portion relative to said second pair of intersecting slots through which N doping is driven into the ends of said NPN transistor to comprise the collector and emitter respectively, said base being comprised of P doped substrate;

said second pair of orthogonal slots filled with substrate oxide; and,

conductors in electrical connection with at least said emitters, bases, and collectors.

9. Complementary transistors each having an active region formed on a common substrate, comprising the steps of:

recessing the substrate substantially along the periphery of each transistor active region;

selectively doping the transistor active regions through portions of the recesses formed by said recessing;

at least partly filling said recesses with substrate oxide to isolate the active regions from said substrate; and,

forming conductors to different portions of each active region to serve as electrode connections.

10. The complementary transistors of Claim 9, wherein:
said doping is accomplished by ion bombardment into electrode portions of said active regions via said portions of said recesses at an angle of less than 90° relative to the substrate.

11. The complementary transistors of Claim 10, wherein:
said rece-sing separates said active regions from the substrate; and,
said substrate oxide envelopes each active region.

FIG. I

FIG.8A

FIG. 2

N or P

N or P

N or P

N or P

N or P

Nor P

27

23

26

25

21

37

37

FIG. 3

N or P

N or P

Nor P

Nor P

23

26

26

21

FIG.4

P

N or P

N or P

25

25

23

26

26

37

FIG.5

N or P

25

Nor P

26

Nor P

27

27

27

27

31

32

33

FIG. 6

FIG. 7

FIG. 8

FIG. 9

FIG. 10

FIG. 11

European Patent
Office

**EUROPEAN SEARCH REPORT**

| | **DOCUMENTS CONSIDERED TO BE RELEVANT** | | | CLASSIFICATION OF THE APPLICATION (Int. Cl. ³) |
|---|---|---|---|---|
| Category | Citation of document with indication, where appropriate, of relevant passages | | Relevant to claim | |
| A | EP - A1 - 0 004 298 (WESTERN ELECTRIC CO) <br> * page 5, line 11 to page 8, line 1 * <br> -- | | 5 | H 01 L 21/76 <br> H 01 L 27/08 |
| A | US -A - 4 104 090 (H.B.POGGE) <br> * fig. 5 * <br> -- | | 11 | |
| A | US - A - 4 214 315 (N.G. ANANTHA et al.) <br> * column 6, line 17 to column 7, line 40 * <br> ---- | | | |

TECHNICAL FIELDS SEARCHED (Int.Cl.³)

H 01 L 21/263
H 01 L 21/308
H 01 L 21/ 76
H 01 L 27/ 08
H 01 L 29/ 06
H 01 L 29/ 72

CATEGORY OF CITED DOCUMENTS

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

| | The present search report has been drawn up for all claims | | |
|---|---|---|---|
| Place of search <br> Berlin | Date of completion of the search <br> 17-09-1982 | Examiner <br> GIBBS | |

EPO Form 1503.1  06.78